(19) Europäisches Patentamt

European Patent Office

Office européen des brevets

(11) **EP 1 617 465 A1**

(12) **EUROPEAN PATENT APPLICATION**
published in accordance with Art. 158(3) EPC

(43) Date of publication:
**18.01.2006 Bulletin 2006/03**

(51) Int Cl.:
***H01L 21/304*** (1974.07)

(21) Application number: **04727407.1**

(22) Date of filing: **14.04.2004**

(86) International application number:
**PCT/JP2004/005310**

(87) International publication number:
**WO 2004/095558 (04.11.2004 Gazette 2004/45)**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **23.04.2003 JP 2003117771**

(71) Applicant: **NIKON CORPORATION**
**Tokyo 100-8331 (JP)**

(72) Inventors:
• **HOSHINO, Susumu**
**Chiyoda-ku,**
**Tokyo 1008331 (JP)**

• **KITADE, Yuko**
**Chiyoda-ku,**
**Tokyo 1008331 (JP)**
• **YOSHIDA, Norio**
**Chiyoda-ku,**
**Tokyo 1008331 (JP)**

(74) Representative: **Viering, Jentschura & Partner**
**Steinsdorfstrasse 6**
**80538 München (DE)**

(54) **CMP POLISHING METHOD AND METHOD FOR MANUFACTURING SEMICONDUCTOR DEVICE**

(57) A wafer substrate having a wiring pattern formed between materials with a dielectric constant of 2 or less is polished with the polishing pressure being set at 0.01 to 0.2 psi. As a result, favorable polishing can be performed even in cases where a ultra-low-k material having the dielectric constant of 2 or less is used as an insulating material.

Fig. 2

EP 1 617 465 A1

## Description

Technical Field

The present invention relates to a method for polishing a wafer substrate on which a wiring pattern is formed between materials having a dielectric constant of 2 or less by means of CMP polishing, and a semiconductor device manufacturing method using this method.

Background Art

As semiconductor integrated circuits have become finer and more highly integrated, the steps of semiconductor manufacturing processes have become more numerous and complex. Consequently, the surfaces of semiconductor devices are not always flat. The presence of steps in the surfaces of semiconductor devices] leads to step breakage in wiring, local increases in resistance, and the like, and may cause wire breakage, a drop in electrical capacity, and the like. Furthermore, in the insulating films, this may lead to a deterioration in the withstand voltage, the occurrence of leakage, or the like.

Meanwhile, as semiconductor integrated circuits have become finer and more highly integrated, the light source wavelengths in photolithography have become shorter, and the numerical aperture or so-called NA has become larger. As a result, the focal depths of semiconductor exposure apparatuses have become substantially shallower. In order to handle such shallow focal depths, there has been demand for a greater degree of flattening of the surfaces of semiconductor devices than in the past.

CMP polishing technology (chemical mechanical polishing or chemical mechanical planarization) has been put to practical use as a high-precision flattening technique for meeting such demand.

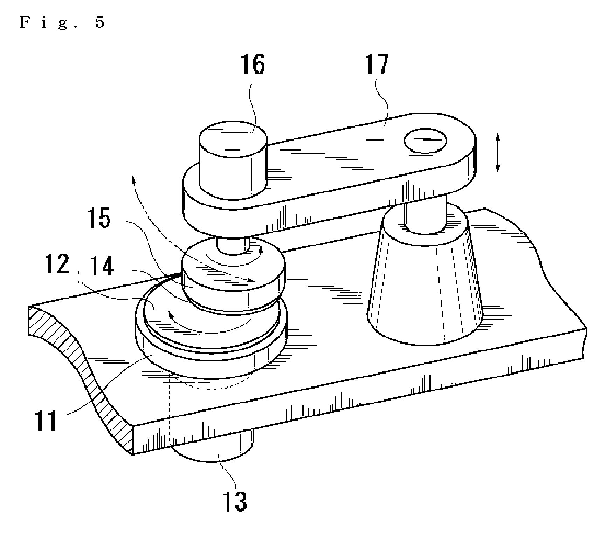

The basic construction of a CMP apparatus is shown in Figure 5. 11 is a head part that causes rotation while holding a wafer substrate 12 which constitutes the object of polishing; this head part has a rotational driving mechanism 13. A rotating platen 15 to which a polishing pad 14 is pasted and a rotational driving mechanism 16 for this platen 15 are present facing this head part 11. The polishing pad 14, rotating platen 15 and rotational driving mechanism 16 are subjected to swinging by a rotational swinging arm 17, and are also driven in the vertical direction.

When polishing is performed using such a CMP polishing apparatus, the wafer substrate 12 and polishing pad 14 are caused to rotate at a high speed, and the rotational swinging arm 17 is lowered by a vertical driving mechanism (not shown in the figure), so that pressure is applied to the wafer substrate 12 by the polishing pad 14. Then, a slurry constituting the polishing agent is supplied between the polishing pad 14 and wafer substrate 12. Furthermore, the rotational swinging arm 17 is caused to swing as indicated by the broken line arrow by means of a swinging driving mechanism (not shown in the figure). Then, as a result of the relative rotation and swinging of the polishing pad 14 and wafer substrate 12, the wafer substrate 12 is polished, and the surface is flattened. Specifically, the mechanical polishing caused by the relative motion of the polishing pad 14 and wafer substrate 12 and the chemical polishing caused by the slurry act synergistically, so that favorable polishing is performed.

The line width of the patterns required in semiconductor devices is becoming increasingly finer, and patterns with a line width of approximately 50 nm have recently been put to a practical use. However, when the line width becomes thus finer, the wiring delay determined by the product of the electrical resistance (R) of the wiring patterns and the capacitance (C) of an insulator is increased by the delay in the semiconductor device; as a result, a problem arises in that the benefits of the increase in speed by the miniaturization cannot be obtained. Accordingly, insulators with a dielectric constant of 2 or less (ultra-low-k) have been used. Generally, the dielectric constant of $SiO_2$ constituting the insulator formed on a wafer substrate is approximately 3.9 to 4.5, which is significantly greater. Therefore, a method for making $SiO_2$ porous has been used as a method for lowering the dielectric constant while using $SiO_2$ as an insulator.

However, if $SiO_2$ is made porous, the mechanical strength is correspondingly weakened, so that the following problem occurs: namely, when CMP polishing is performed, stripping occurs, and favorable polishing cannot be performed. Accordingly, it has been desired to develop a method for polishing a wafer substrate having a ultra-low-k insulating material in a favorable manner.

Disclosure of the Invention

The present invention was devised in light of such circumstances, and the object of the present invention is to provide a method for performing favorable polishing even in cases where a ultra-low-k material, whose dielectric constant is 2 or less, especially a porous material, is used as the insulating material, and also to provide a semiconductor device manufacturing method using this polishing method.

The first invention that is used to achieve the object described above is a CMP polishing method, wherein a wafer substrate having a wiring pattern formed between materials with a dielectric constant of 2 or less is polished with the polishing pressure being set at 0.01 to 0.2 psi.

The second invention that is used to achieve the object described above is the first invention, wherein polishing is performed with the polishing pressure being set at 0.01 to 0.1 psi.

The third invention that is used to achieve the object described above is the first invention or second invention, wherein the materials with a dielectric constant of 2 or less are porous insulating materials, and the wafer substrate is polished using a polishing pad having a diameter smaller than that of the wafer substrate in a state in which the macroscopic flatness of the surface of the polishing pad is maintained at 5 μm or less, and the macroscopic flatness of the surface of the wafer substrate is maintained at 3 μm or less.

As a result of the research conducted on methods for favorably polishing ultra-low-k materials, the inventor discovered that with such fragile materials, it is an essential condition to maintain both the macroscopic flatness of the surface of the polishing pad and the macroscopic flatness of the wafer substrate constituting the object of polishing at a specified value or less, which was not much of an issue in conventional CMP apparatuses. Here, the macroscopic flatness does not refer to minute irregularity, but rather refers to the difference between the maximum value and the minimum value in the height of the surface in a case where such minute irregularity is seen on an average. The reason for requiring such a measure is not always clear; however, it is considered that if the flatness is poor, the pressure does not act uniformly during polishing. Furthermore, it was discovered that favorable polishing cannot be performed unless the macroscopic flatness of the surface of the polishing pad is 5 μm or less, and the macroscopic flatness of the surface of the wafer substrate is 3 μm or less.

Moreover, it was discovered that the polishing pressure needs to be set at 0.01 to 0.2 psi under such a condition. If the polishing pressure is less than 0.01 psi, it becomes difficult to uniformly control the pressure during polishing. Furthermore, if the polishing pressure exceeds 0.2 psi, stripping is generated in the insulating material, so that favorable polishing cannot be performed. This pressure range is significantly low, unlike the range that was conventionally used. It is especially desirable that the polishing pressure be set at 0.1 psi or less.

The fourth invention that is used to achieve the object described above is the third invention, wherein polishing is performed with the relative velocity between the polishing pad and wafer substrate being set at 6.5 m/sec or lower.

The Preston equation shown in Equation (1) is widely known as an equation that determines the amount of polishing of the object of polishing.

$$[\text{Amount of polishing}] = k \cdot V \cdot P \cdot t \ \dots \ (1)$$

Here, k is a constant, V is the relative velocity of the polishing body and object of polishing, P is the pressure at which the object of polishing is pressed against the polishing body, and t is the polishing time.

Accordingly, if the polishing pressure P is reduced, the amount of polishing is reduced, so that the required polishing time is increased. In order to prevent this, it is necessary to increase the relative velocity V of the polishing body and the wafer substrate constituting the object of polishing. However, when this relative velocity V is increased beyond a certain level, the slurry that is present between the polishing pad and wafer substrate causes hydroplaning phenomenon, so that the amount of polishing becomes saturated. Therefore, it is meaningless to increase the relative velocity V any higher than this level. Thus, the relative velocity between the polishing pad and wafer substrate is restricted to 6.5 m/sec or lower on the basis of the experimental results.

Although this was not conventionally known, if polishing is performed at such a low polishing pressure as that described above, and the polishing speed is to be increased to a level that causes the saturation of the amount of polishing due to the hydroplaning phenomenon as described above, then the polishing rate varies according to the location of the wafer substrate, so that uniform polishing cannot be obtained. Accordingly, it is preferable to suppress the actual relative velocity between the polishing pad and wafer substrate to an even lower level. The inventor discovered that as long as the relative velocity between the polishing pad and wafer substrate is 6.5 m/sec or lower, variation in the polishing rate presents no practical problem. Furthermore, if the polishing rate is excessively low, the polishing time is increased; therefore, it is desirable that the relative velocity between the polishing pad and wafer substrate be set at 3.0 m/sec or higher.

The fifth invention that is used to achieve the object described above is a semiconductor device manufacturing method, wherein this method has a step of polishing the wafer substrate by means of the CMP polishing method according to any of the first through fourth inventions.

In this invention, since the method has a step of polishing the wafer substrate by means of the CMP polishing method according to one of the first through fourth inventions, the wafer substrate having a ultra-low-k insulating material can be polished in a favorable manner. Consequently, it is possible to manufacture, with a good yield, semiconductor devices having high-density patterns with a very fine line width.

Brief Description of the Drawings

Figure 1 is a diagram showing the relationship between the rotational speed (rpm) of the polishing pad, the polishing speed (relative velocity of the polishing pad and wafer substrate), and the polishing rate in a polishing method constituting an embodiment of the present invention.

Figure 2 is a diagram showing the distribution of the polishing rate in the direction of the radius of the wafer substrate in a polishing method constituting an embodiment of the present invention with the rotational speed (rpm) of the polishing pad taken as a parameter.

Figure 3 is a diagram showing another experimental data indicating the polishing rate in the direction of the radius of the wafer substrate in a polishing method constituting an embodiment of the present invention.

Figure 4 is a flow chart showing a semiconductor device manufacturing process constituting a working configuration of the present invention.

Figure 5 is a diagram showing the basic construction of a CMP apparatus.

Best Mode for Carrying Out the Invention

An embodiment and a working configuration of the present invention will be described below with reference to the figures.

CMP polishing is performed on a wafer substrate which has a diameter of 300 mm and on one surface of which 25-mm-square IC regions are formed, with each of the IC regions having a pattern with a 0.1-$\mu$m line and space formed thereon. The lines are formed from Cu, and the portions of the space are formed from porous $SiO_2$ having a dielectric constant of 2 or less. The polishing pad consists of an IC1000 (commercial name) by Rodel, Inc., and a doughnut type pad is used which has a diameter of 266 mm and in which a hole with a diameter of 84 mm is formed in the central portion. PL7102 (commercial name) by Fujimi Incorporated is used as the slurry, with a supply of 150 ml/min. The rpm of the wafer substrate is 251 rpm, with this rotation oriented in the opposite direction from the direction of rotation of the polishing pad, and the oscillation velocity of the polishing pad is set at 40 mm/sec. The oscillation range is in a range of 30 to 80 mm from the center of the wafer substrate.

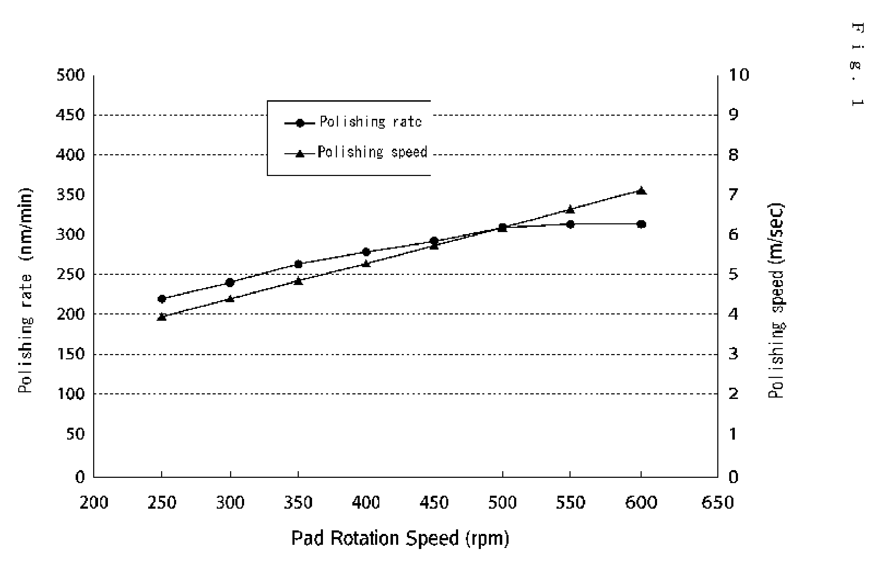

Figure 1 is a diagram showing the relationship between the rotational speed (rpm) of the polishing pad, the polishing speed (relative velocity of the polishing pad and wafer substrate), and the polishing rate. The polishing pressure in this case is 0.01 psi. As the rpm of the polishing pad increases, the polishing speed also increases, so that the polishing rate is also increased. However, when the polishing speed reaches 6.5 m/sec (rpm of the polishing pad: 550 rpm), the polishing rate reaches saturation. This is due to hydroplaning phenomenon. Furthermore, since the polishing speed also varies according to the position of oscillation of the polishing pad, average values are used.

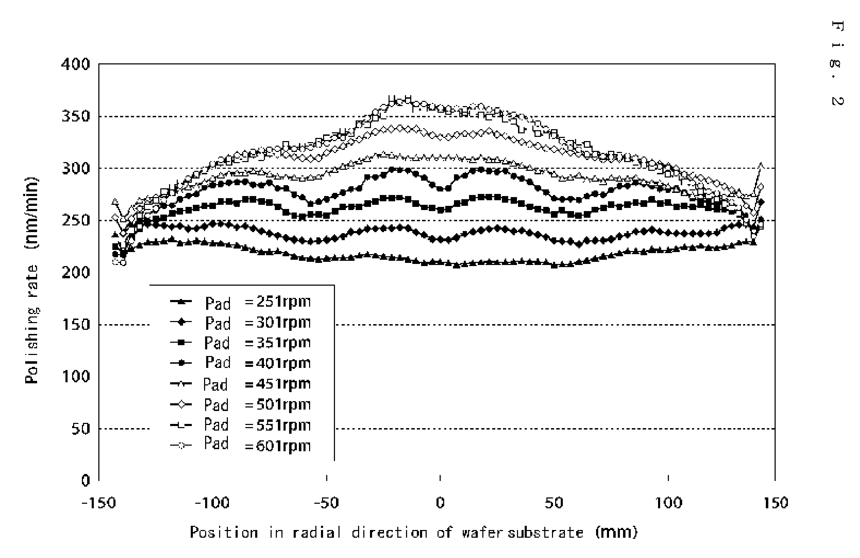

Figure 2 is a diagram showing the distribution of the polishing rate in the direction of the radius of the wafer substrate, with this distribution investigated under the same conditions as in Figure 1 and with the rotational speed (rpm) of the polishing pad taken as a parameter. It is seen from this diagram that there is almost no difference in the polishing rate between the case where the rpm of the polishing head is 551 rpm and the case where this rpm is 601 rpm, and that when the rpm of the polishing pad reaches 550 rpm or greater as described above, i.e., when the polishing speed reaches 6.5 m/sec or greater, the polishing rate becomes saturated.

Furthermore, it is seen that even if the polishing rate is lower than that, there is relatively little difference in the polishing rate over the entire wafer substrate up to an rpm of the polishing pad of 401 rpm, but at 451 rpm, which exceeds this rate, the difference in the polishing rate over the entire wafer substrate is increased. When this is seen in correspondence with Figure 1, when the rpm of the polishing pad is 401 rpm (approximately 400 rpm), the polishing speed corresponds to approximately 5.5 m/sec. It is apparent from Figure 2 that as the polishing speed is lower, the polishing rate is generally maintained more uniformly in various portions of the wafer substrate.

Moreover, in the data range shown in Figure 2, in spite of the fact that ultra-low-k porous $SiO_2$ is used as the insulating material, there is no crushing, stripping, or the like of the insulating material, and it is possible to perform favorable polishing.

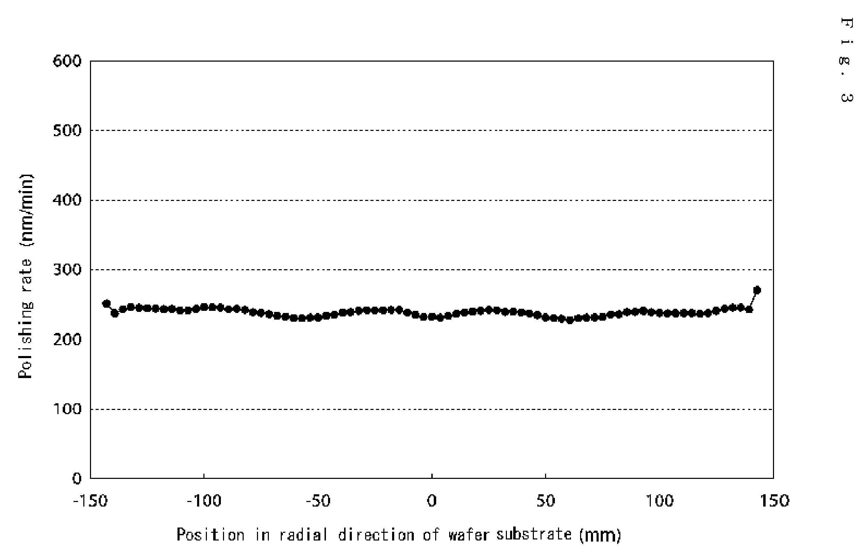

Figure 3 is a diagram showing another experimental data indicating the polishing rate in the direction of the radius of the wafer substrate in a case where the rpm of the polishing pad is set at 301 rpm, i.e., the polishing speed is set at 4.4 m/sec, under the same conditions as described above. It is seen that substantially uniform polishing rates are obtained over the entire region of the wafer substrate.

Polishing is performed using a similar method with the polishing pressure being changed to 0.05 psi and to 0.1 psi but with the other conditions being the same; there is no crushing, stripping, or the like of the ultra-low-k porous insulating material, so that favorable polishing is performed. However, when the polishing pressure is set at a pressure that exceeds 0.2 psi, crushing of the insulating material is generated, and the state of polishing deteriorates.

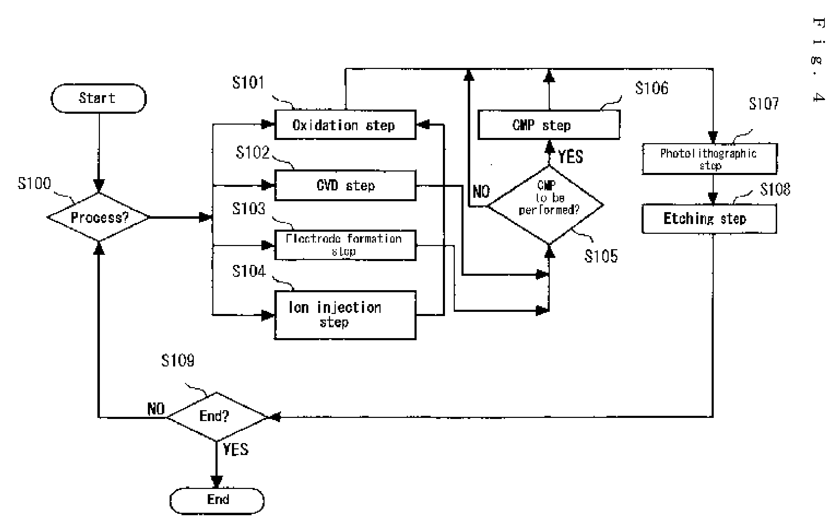

Figure 4 is a flow chart showing a semiconductor device manufacturing process constituting a working configuration of the present invention. When the semiconductor device manufacturing process is started, the appropriate treatment process is first selected in step S100 from the following steps S101 through S104. Then, the processing proceeds to one of the steps S101 through S104 in accordance with this selection.

Step S101 is an oxidation process which oxidizes the surface of the silicon wafer substrate. Step S102 is a CVD process in which an insulating film is formed on the surface of the silicon wafer substrate by CVD or the like. Step S103 is an electrode formation process in which electrodes are formed on the silicon wafer substrate by a process such as vacuum evaporation. Step S104 is an ion injection process in which ions are injected into the silicon wafer substrate.

Following the CVD process or electrode formation process, the processing proceeds to step S105. In step S105, a judgment is made as to whether or not a CMP process is to be performed. In cases where such a process is to be performed, the processing proceeds to the CMP process in step S106. In cases where a CMP process is not to be performed, the processing bypasses step S106. In the CMP process, the flattening of inter-layer insulating films, the formation of a damascene by the polishing of a metal film on the surface of the semiconductor device, and the like are performed using the polishing apparatus that implements the polishing method of the present invention.

Following the CMP process or oxidation process, the processing proceeds to step S107. Step S107 is a photolithographic process. In the photolithographic process, the coating of the silicon wafer substrate with a resist, the burning of a circuit pattern onto the silicon wafer substrate by exposure using an exposure apparatus, and the development of the exposed silicon wafer substrate, are performed. Furthermore, the subsequent step S108 is an etching process in which the portions other than the developed resist image are removed by etching, the resist is then stripped away, and the unnecessary resist following the completion of etching is removed.

Next, in step S109, a judgment is made as to whether or not all of the required processes have been completed. If the processes have not been completed, the processing returns to step S100, and the preceding steps are repeated so that a circuit pattern is formed on the silicon wafer substrate. If it is judged in step S109 that all of the processes have been completed, the processing is ended.

## Claims

1. A CMP polishing method, wherein a wafer substrate having a wiring pattern formed between materials with a dielectric constant of 2 or less is polished with the polishing pressure being set at 0.01 to 0.2 psi.

2. The CMP polishing method according to Claim 1, wherein polishing is performed with the polishing pressure being set at 0.01 to 0.1 psi.

3. The CMP polishing method according to Claim 1, wherein the materials with a dielectric constant of 2 or less are porous insulating materials, and the wafer substrate is polished using a polishing pad having a diameter smaller than that of the wafer substrate in a state in which the macroscopic flatness of the surface of the polishing pad is maintained at 5 $\mu$m or less, and the macroscopic flatness of the surface of the wafer substrate is maintained at 3 $\mu$m or less.

4. The CMP polishing method according to Claim 3, wherein polishing is performed with the relative velocity between the polishing pad and the wafer substrate being set at 6.5 m/sec or lower.

5. The CMP polishing method according to Claim 2, wherein the materials with a dielectric constant of 2 or less are porous insulating materials, and the wafer substrate is polished using a polishing pad having a diameter smaller than that of the wafer substrate in a state in which the macroscopic flatness of the surface of the polishing pad is maintained at 5 $\mu$m or less, and the macroscopic flatness of the surface of the wafer substrate is maintained at 3 $\mu$m or less.

6. The CMP polishing method according to Claim 5, wherein polishing is performed with the relative velocity between the polishing pad and the wafer substrate being set at 6.5 m/sec or lower.

7. A semiconductor device manufacturing method, wherein this method has a step of polishing the wafer substrate by means of the CMP polishing method according to any one of Claims 1 through 6.

Fig. 1

Fig. 2

Pad = 251rpm
Pad = 301rpm
Pad = 351rpm
Pad = 401rpm
Pad = 451rpm
Pad = 501rpm
Pad = 551rpm
Pad = 601rpm

F i g . 3

Fig. 4

EP 1 617 465 A1

F i g . 5

## INTERNATIONAL SEARCH REPORT

International application No.

PCT/JP2004/005310

**A. CLASSIFICATION OF SUBJECT MATTER**
Int.Cl⁷ H01L21/304

According to International Patent Classification (IPC) or to both national classification and IPC

**B. FIELDS SEARCHED**

Minimum documentation searched (classification system followed by classification symbols)
Int.Cl⁷ H01L21/304

Documentation searched other than minimum documentation to the extent that such documents are included in the fields searched

| | | | |
|---|---|---|---|
| Jitsuyo Shinan Koho | 1922–1996 | Toroku Jitsuyo Shinan Koho | 1994–2004 |
| Kokai Jitsuyo Shinan Koho | 1971–2004 | Jitsuyo Shinan Toroku Koho | 1996–2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2002-353223 A (Sony Corp.), 06 December, 2002 (06.12.02), Par. Nos. [0012] to [0014] (Family: none) | 1-7 |
| A | JP 2003-68683 A (Hitachi Chemical Co., Ltd.), 07 March, 2003 (07.03.03), Par. No. [0008] (Family: none) | 1-7 |
| P,A | JP 2003-324088 A (Sony Corp.), 14 November, 2003 (14.11.03), Page 3, right column, lines 24 to 28 (Family: none) | 1-7 |

☐ Further documents are listed in the continuation of Box C.   ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 23 July, 2004 (23.07.04) | 10 August, 2004 (10.08.04) |

| Name and mailing address of the ISA/ | Authorized officer |
|---|---|
| Japanese Patent Office | |
| Facsimile No. | Telephone No. |

Form PCT/ISA/210 (second sheet) (January 2004)